Europäisches Patentamt

European Patent Office

Office européen des brevets

(19)

(11) Veröffentlichungsnummer: **0 374 121**
**A2**

## (12) EUROPÄISCHE PATENTANMELDUNG

(21) Anmeldenummer: 89890285.3

(22) Anmeldetag: 31.10.89

(51) Int. Cl.⁵: **H01L 33/00**

(30) Priorität: 16.12.88 AT 3069/88

(43) Veröffentlichungstag der Anmeldung:
20.06.90 Patentblatt 90/25

(84) Benannte Vertragsstaaten:
BE CH DE FR GB IT LI LU NL SE

(71) Anmelder: **RSF-Elektronik Gesellschaft m.b.H.**

**A-5121 Tarsdorf 93(AT)**

(72) Erfinder: **Rieder, Heinz**
**Riedersbach 90**
**A-5120 St. Pantaleon(AT)**
Erfinder: **Schwaiger, Max**
**Nr. 298**
**A-5121 Ostermiething(AT)**

(74) Vertreter: **Hübscher, Heiner, Dipl.-Ing. et al**
**Spittelwiese 7**
**A-4020 Linz(AT)**

(54) **Leuchtdiode.**

(57) Bei einer insbesondere für die Verwendung in Abtasteinheiten von Längen- und Winkelmeßgeräten mit optoelektronischer Abtastung bestimmten Leuchtdiode (7), die mit ihrer Unterseite auf einem den einen Anschlußkontakt der Diode bildenden elektrisch leitenden Träger (1) sitzt und von deren Oberseite die zweite Zuleitung (8) ausgeht, sind Einrichtungen vorzusehen, die eine Abstrahlung von Streulicht von den Seitenflächen der Leuchtdiode (7) in der Hauptabstrahlrichtung verhindern. Um dies ohne wesentliche Vergrößerung des baulichen Aufwandes und der Herstellungskosten zu ermöglichen, ist die Leuchtdiode (7) unter Einhaltung eines seitlichen Spieles zur Gänze in eine Vertiefung des Trägers (1) versenkt und der Freiraum der Vertiefung (5) ist mit einer lichtundurchlässigen, isolierenden Vergußmasse (12) ausgefüllt.

## Leuchtdiode

Die Erfindung betrifft eine Leuchtdiode, die insbesondere, aber nicht ausschließlich für die Verwendung in Abtasteinheiten von Längen- und Winkelmeßgeräten mit optoelektronischer Abtastung bestimmt ist, bei denen die Leuchtdiode einen ein Abtastsignal erzeugenden photoelektrischen Empfänger über eine Meßteilung und ein Abtastgitter beleuchtet, wobei die Leuchtdiode mit ihrer Unterseite auf einem elektrisch leitenden Träger sitzt, der in der Draufsicht gesehen im gesamten Umfangsbereich über die Diode vorragt und zugleich als Träger für eine durchsichtige Abdeckung dienen kann, sowie den einen Anschlußkontakt der Diode bildet, von der Oberseite der Diode die zweite Zuleitung ausgeht und lichtabsorbierende bzw. -undurchlässige Abdeckungen vorgesehen sind, die eine Abstrahlung von Streulicht in der Hauptabstrahlrichtung der Leuchtdiode verhindern.

Eine Leichtdiode dieser Art ist aus der EP-B1-0 147 514 bekannt.

Bei Längen- und Winkelmeßgeräten mit optoelektronischer Abtastung wird das von der Leuchtdiode ausgehende Licht durch die relativ zum Maßstab verstellte Gitterteilung des Abtastgitters und die Maßstabteilung moduliert und erzeugt am photoelektrischen Empfänger ein entsprechend moduliertes periodisches Signal, das zu Meßsignalen weiterverarbeitet werden kann. Der Modulationsgrad und die Form der erhaltenen Signale wird durch Streulicht von den Seitenflächen der Leuchtdiode nachteilig beeinflußt. Es sollen daher Maßnahmen gesetzt werden, um zu verhindern, daß dieses Streulicht zum photoelektrischen Empfänger gelangt.

Es ist bekannt, der Leuchtdiode Kollimatorlinsen und Lochblenden zur Abschirmung von Streulicht nachzuordnen, doch stellen diese Lochblenden zusätzlich anzubringende und zu justierende Bauteile dar, die überdies die gesamte Lichtausbeute und damit die Amplitude der erzeugten Meßsignale herabsetzen.

Aus der EP-B1-0 147 514 ist es bekannt, den Träger der Leuchtdiode mit einer lichtabsorbierenden Oberflächenbeschichtung zu versehen oder die Trägeroberfläche nach dem Anbringen der Leuchtdiode im Umgebungsbereich dieser Diode entsprechend zu beschichten. Wird die Diode auf einen beschichteten Träger aufgesetzt, so muß die Oberflächenbeschichtung elektrisch leitend sein. Die nachträgliche Anbringung einer die ganze in Abstrahlrichtung der Diode weisende Fläche des Trägers bedeckenden Beschichtung ist umständlich, wobei zu bedenken ist, daß häufig an dieser Beschichtung noch ein auch die Diode umschließender, meist kugeliger Abdeckkörper aus durchsichtigem Kunststoff angebracht werden muß. Schließlich wird noch vorgeschlagen, für Luminiszenzdioden einen Träger zu verwenden, der in der Projektion der Abstrahlrichtung gesehen nur gleich groß oder kleiner als die Diode ist, welche Ausbildung nur in Sonderfällen realisierbar ist.

Aus der DE-C 25 54 398 ist es bekannt, zur Erzielung einer engen Packungsdichte Leuchtdioden auf einer Platine anzubringen und zum Kontaktanschluß der Diodenoberseite in Blechstreifen Fenster für die Leuchtdioden vorzusehen. Die Dioden selbst werden in eine Vertiefung des aus isolierendem Kunststoff bestehenden Platinenkörpers eingelegt, vor dem Einlegen durch Galvanisierung mit einer Metallschicht versehen und mit dem oberen Anschlußkontakt durch Lötung verbunden, wobei eine gebildete Nut das Lötmaterial teilweise aufnimmt. Es wird zwar eine Lichtabstrahlung von den Seitenflächen der Leuchtdioden verhindert, doch kommt es zu Reflexionen an den sich bildenden wulstförmigen Lötbrücken, deren Form variieren kann, so daß weiterhin keine gerichtete Lichtabstrahlung stattfindet. Die Anbringung einer Abdeckung ist hier unmöglich.

Aus der US-A-4 375 606 ist es bekannt, Leuchtdiodenelemente mit allseitigem Umfangsabstand in einem Reflektorbecher anzuordnen, um die Lichtausbeute zu verbessern. Hier wird vorwiegend das von den Seitenflächen der Leuchtdioden kommende Licht, dessen Abstrahlrichtung nicht eindeutig definiert ist, ausgenützt.

Zur Erzeugung sehr feiner Lichtpunkte in engem Raster ist es aus der DE-C-26 41 540 bekannt, die Leuchtdioden in Kunststoff einzubetten, aus dem nur eine Seitenfläche jedes Elementes hervorragt, wobei die mit den beiden Hauptseiten der Diodenelemente verbundenen Anschlußkontakte in den Kunststoff eingebettet sind.

Aus der DE-A-31 17 571 ist eine Abdeckkappe für Leuchtdioden bekannt, wobei die Leuchtdioden in Reflektorbechern mit allseitigem Abstand angebracht werden. Die Abdeck kappe enthält Füllmaterial verschiedener Zusammensetzung, um die Streueigenschaft und die Filtercharakteristik für das von der Leuchtdiode ausgesandte Licht variieren zu können.

Aufgabe der Erfindung ist die Schaffung einer Leuchtdiode der eingangs genannten Art, bei der das Problem der Verhinderung der Abstrahlung von Streulicht in der Hauptabstrahlrichtung mit einfachen Mitteln und ohne wesentliche Erhöhung des Gesamtherstellungsaufwandes der Diode und ihrer Trageinrichtung gelöst ist, wobei insbesondere die Notwendigkeit der Anbringung gesonderter Oberflächenbeschichtungen am Träger oder die Verwendung von Lochblenden vermieden wird.

Die gestellte Aufgabe wird dadurch gelöst, daß die Leuchtdiode unter Einhaltung eines seitlichen Spiels zur Gänze in eine Vertiefung des den Anschlußkontakt bildenden Trägers versenkt und der Freiraum der Vertiefung mit lichtundurchlässigem Isoliermaterial, insbesondere einer schwarzen Vergußmasse, ausgefüllt ist.

Mit Ausnahme der Anbringung der Vertiefung in der Oberseite des Trägers kann die Herstellung der Leuchtdiode in herkömmlicher Weise und unter Verwendung herkömmlicher, in ihrer Größe genormter oder standardisierter Elemente erfolgen, wobei die Diode eben am Boden der Vertiefung und nicht wie bisher an einer ebenen Fläche des Trägers angebracht wird. Die Einbringung der Vergußmasse ist mit einfachen Mitteln möglich, wobei Größentoleranzen der Leuchtdiode ausgeglichen werden und keine besondere Maßnahmen zum Schutz der Oberseite der Leuchtdiode notwendig sind. Außerhalb der Vertiefung kann der Trägerkörper noch eine genügend große Fläche besitzen, um die haftende Anbringung des meist üblichen Abdeckkörpers aus durchsichtigem Kunststoff zu ermöglichen. Die Vertiefung mit der den Freiraum ausfüllenden, lichtundurchlässigen Füllung haben die Wirkung einer unmittelbar an der Leuchtdiode angebrachten und nur ihre Haupt-Lichtaustrittsfläche freilassenden Lochblende, so daß keine eigene Lochblende mehr benötigt wird. Ein weiterer Vorteil der erfindungsgemäßen Ausführung besteht darin, daß die Leuchtdiode durch die versenkte Anordnung und durch die seitliche Einbettung in der Vergußmasse zusätzlich während der Anbringung einer Kunststoffabdeckung geschützt wird.

Ein bevorzugte Ausführung sieht vor, daß sich die Vertiefung von ihrem die Anschlußfläche für die Leuchtdiode bildenden Boden nach außen konisch erweitert, wodurch das Einsetzen der Diode in die Vertiefung und die Einfüllung der Vergußmasse erleichtert wird.

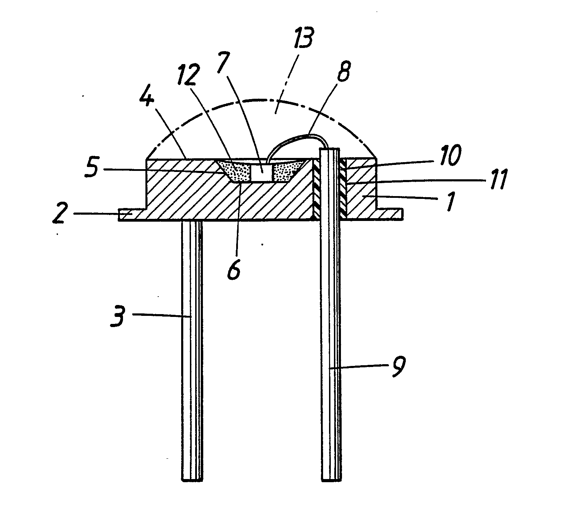

In der Zeichnung ist als Ausführungsbeispiel eine erfindungsgemäße Leuchtdiode im Schnitt durch den Träger dargestellt.

Beim Ausführungsbeispiel ist ein aus Metall gefertigter Träger 1 in Form einer Scheibe mit Außenflansch 2 vorgesehen, welcher Träger 1 mit einem die Anode bildenden Anschlußstift 3 einteilig geformt, zumindest aber elektrisch leitend verbunden ist. In die in Abstrahlrichtung weisende Oberseite 4 des Trägers 1 ist eine Vertiefung 5 eingearbeitet, die sich von ihrem Boden 6 zur Oberseite 4 konisch erweitert. Auf den Boden 6 ist eine Leuchtdiode 7 aufgesetzt, wobei der Boden zugleich eine elektrische Zuleitung für die Diode 7 bildet. Von der Oberseite der Diode geht ein Anschlußdraht 8 zu dem Kontaktstift 9, der den Kathodenanschluß für die Diode 7 bildet und durch eine mit einer Isolierung 10 ausgekleidete Bohrung 11 des Trägers 1 geführt ist. Die Vertiefung 5 ist bereits im Bereich ihres Bodens 6 größer als die Projektionsfläche der Leuchtdiode. Es können daher Größenabweichungen für die Leuchtdiode 7 toleriert werden. Der Freiraum der Vertiefung 5 ist mit einer auch die Seitenflächen der Diode bedeckenden, isolierenden, schwarzen Vergußmasse ausgefüllt. Über der Oberseite 4 des Trägers 1 wird eine auch die Leuchtdiode 4 abdeckende und den Draht 8 aufnehmende kugelförmige Abdeckung 13 aus durchsichtigem Kunststoff, z. B. Epoxyharz, angebracht werden.

## Ansprüche

1. Leuchtdiode, insbesondere für die Verwendung in Abtasteinheiten von Längen- und Winkelmeßgeräten mit optoelektronischer Abtastung, bei denen die Leuchtdiode (7) einen ein Abtastsignal erzeugenden photoelektrischen Empfänger über eine Meßteilung und ein Abtastgitter beleuchtet, wobei die Leuchtdiode mit ihrer Unterseite auf einem elektrisch leitenden Träger (1) sitzt, der in der Draufsicht gesehen im gesamten Umfangsbereich über die Diode (7) vorragt und zugleich als Träger für eine durchsichtige Abdeckung (13) dienen kann sowie den einen Anschlußkontakt der Diode (7) bildet, von der Oberseite der Diode die zweite Zuleitung (8) ausgeht und lichtabsorbierende bzw. -undurchlässige Abdeckungen (12) vorgesehen sind, die eine Abstrahlung von Streulicht in der Hauptabstrahlrichtung der Leuchtdiode verhindern, dadurch gekennzeichnet, daß die Leuchtdiode (7) unter Einhaltung eines seitlichen Spiels zur Gänze in eine Vertiefung (5) des den Anschlußkontakt bildenden Trägers (1) versenkt und der Freiraum der Vertiefung mit lichtundurchlässigem Isoliermaterial, insbesondere einer schwarzen Vergußmasse (12), ausgefüllt ist.

2. Leuchtdiode nach Anspruch 1, dadurch gekennzeichnet, daß die Vertiefung (5) sich von ihrem die Anschlußfläche für die Leuchtdiode bildenden Boden (6) nach außen konisch erweitert.